# EUROPEAN PATENT APPLICATION

(11) **EP 3 786 710 A1**
(43) Date of publication of application: **03.03.2021**
(21) Application number: 19792971.4
(22) Date of filing: 26.04.2019
(51) Int. Cl.: G03F 7/11, C08G 79/00, G03F 7/075, G03F 7/20, G03F 7/26

(54) **RESIST UNDERLAYER FILM-FORMING COMPOSITION, UNDERLAYER FILM FOR LITHOGRAPHY, AND PATTERN FORMATION METHOD**

(30) Priority: 27.04.2018 JP 2018086443
(71) Applicant: MITSUBISHI GAS CHEMICAL COMPANY, INC., Chiyoda-ku Tokyo 100-8324 (JP)
(72) Inventor: SATO, Takashi, Hiratsuka-shi, Kanagawa 254-0016 (JP); ECHIGO, Masatoshi, Tokyo 100-8324 (JP); MAKINOSHIMA, Takashi, Hiratsuka-shi, Kanagawa 254-0016 (JP)
(74) Representative: Müller-Boré & Partner Patentanwälte PartG mbB
(86) International application number: PCT/JP2019/017905
(87) International publication number: WO 2019/208762

(57) **Abstract**

A composition for resist underlayer film formation comprising a compound represented by the following formula (1) and a silicon containing compound:

[LₓTe(OR¹)_{y}] (1)

(In formula (1), L is a ligand other than OR¹; R¹ is any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, and a substituted or unsubstituted alkenyl group having 2 to 20 carbon atoms; x is an integer of 0 to 6; y is an integer of 0 to 6; the sum of x and y is 1 to 6; when x is 2 or more, a plurality of L may be the same or different; and when y is 2 or more, a plurality of R¹ may be the same or different.)

## Description

### Technical Field

The present invention relates to a composition for resist underlayer film formation, an underlayer film for lithography, and a pattern formation method.

### Background Art

In the production of semiconductor apparatuses, fine processing has been conventionally practiced by lithography using photoresist. The fine processing is a processing method including: forming a thin film of photoresist on a semiconductor substrate such as silicon wafer at first, irradiating the substrate with active rays such as ultraviolet ray through a mask pattern having a pattern of a semiconductor device, developing the substrate to form a photoresist pattern, then subjecting the substrate to etching treatment using the photoresist pattern as a protective film to form fine projections and recesses corresponding to the pattern on a substrate surface. However, along with a recent increase in the integration degree of semiconductor devices, active rays to be used tend to become shorter from a KrF excimer laser (248 nm) to an ArF excimer laser (193 nm) and EUV (Extreme ultraviolet) light (13.5 nm). As a result, the influence of the reflection of active rays from the semiconductor substrate has become a major problem.

As an underlayer film between a semiconductor substrate and a photoresist, a film that is known as a hard mask containing a metal element such as silicon has been used (for example, see the following Patent Literature 1).

### Citation List

### Patent Literature

Patent Literature 1: Japanese Patent Laid-Open No. 7-183194

### Summary of Invention

### Technical Problem

Since a photoresist and a hard mask have a large difference in their constituent components, their removing rates by dry etching significantly depend on a type of gas used in the dry etching. Appropriate selection of the type of gas enables the removal of the hard mask by dry etching without no significant decrease in the film thickness of the photoresist. Thus, in the production of semiconductor apparatuses in recent years, miniaturization is difficult to achieve only by using an upper layer resist (photoresist). In order to achieve not only the antireflection effect, but also various effects, a miniaturization process cannot be readily established without utilizing a hard mask formed in an under layer of an upper layer resist. Furthermore, various multilayer resist methods in which a resist underlayer film is provided between an upper layer resist (for example, a photoresist, an electron beam resist, and an EUV resist) and a hard mask have been developed. Such a resist underlayer film causes no intermixing with the upper layer resist, has heat resistance, and has a faster etching rate than a mask (an upper layer resist patterned) during patterning so that a good rectangular pattern is obtained. Since such a resist underlayer film functions as a mask during the patterning of a layer provided on a base material such as a hard mask or an organic underlayer film, the resist underlayer film is required to exhibit the etching resistance.

An object of the present invention is to provide a composition for resist underlayer film formation excellent in pattern formability, an underlayer film for lithography, and a pattern formation method.

### Solution to Problem

The present inventors have intensively studied to solve the problem and found that a composition for resist underlayer film formation comprising a compound having a specific structure and a silicon containing compound is excellent in pattern formability, thereby leading to the present invention.

More specifically, the present invention is as follows.
[1] A composition for resist underlayer film formation comprising a compound represented by the following formula (1) and a silicon containing compound:

   [LₓTe(OR¹)_{y}] (1)

   wherein L is a ligand other than OR¹; R¹ is any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, and a substituted or unsubstituted alkynyl group having 2 to 20 carbon atoms; x is an integer of 0 to 6; y is an integer of 0 to 6; the sum of x and y is 1 to 6; when x is 2 or more, a plurality of L may be the same or different; and when y is 2 or more, a plurality of R¹ may be the same or different.
[2] A composition for resist underlayer film formation comprising a tellurium containing silicon compound being a reaction product of the compound represented by formula (1) and a silicon containing compound.
[3] The composition for resist underlayer film formation according to [1] or [2], wherein the silicon containing compound is a hydrolyzable organosilane, a hydrolysate thereof, or a hydrolysis condensate thereof.
[4] The composition for resist underlayer film formation according to any of [1] to [3], wherein, in the compound represented by formula (1), x is an integer of 1 to 6.
[5] The composition for resist underlayer film formation according to any of [1] to [4], wherein, in the compound represented by formula (1), y is an integer of 1 to 6.
[6] The composition for resist underlayer film formation according to any of [1] to [5], wherein, in the compound represented by formula (1), R¹ is a substituted or unsubstituted linear alkyl group having 1 to 6 carbon atoms or branched or cyclic alkyl group having 3 to 6 carbon atoms.
[7] The composition for resist underlayer film formation according to any of [1] to [6], wherein, in the compound represented by formula (1), L is a bi- or higher dentate ligand.
[8] The composition for resist underlayer film formation according to any of [1] to [6], wherein, in the compound represented by formula (1), L is any of acetylacetonato, 2,2-dimethyl-3,5-hexanedione, ethylenediamine, diethylenetriamine, and methacrylic acid.
[9] The composition for resist underlayer film formation according to any of [1] to [8], further comprising a solvent.
[10] The composition for resist underlayer film formation according to any of [1] to [9], further comprising an acid generating agent.
[11] The composition for resist underlayer film formation according to any of [1] to [10], further comprising an acid crosslinking agent.
[12] The composition for resist underlayer film formation according to any of [1] to [11], further comprising an acid diffusion controlling agent.
[13] The composition for resist underlayer film formation according to any of [1] to [12], further comprising a polymerization initiator.
[14] The composition for resist underlayer film formation according to any of [1] to [13], wherein the silicon containing compound is at least one hydrolyzable organosilane selected from the group consisting of a compound represented by the following formula (D1), a compound represented by (D2), and a compound represented by (D3), a hydrolysate thereof, or a hydrolysis condensate thereof:

   (R³)ₐSi(R⁴)₄₋ₐ... (D1)

   wherein R³ represents an alkyl group, an aryl group, an aralkyl group, a halogenated alkyl group, a halogenated aryl group, a halogenated aralkyl group, an alkenyl group, an epoxy group, an acryloyl group, a methacryloyl group, an alkoxyaryl group, an acyloxyaryl group, or a cyano group, or a group obtained by combining two or more of these groups, which groups optionally have a mercapto group, an isocyanurate group, a hydroxy group, or cyclic amino group as a substituent; R⁴ represents an alkoxy group, an acyloxy group, or a halogen group; and a represents an integer of 0 to 3,

   [(R⁵)_{c}Si(R⁶)_{4-c}]₂Y... (D2)

   (R⁵)_{c}Si(R⁶)_{4-c}... (D3)

   wherein R⁵ represents an alkyl group; R⁶ represents an alkoxy group, an acyloxy group, or a halogen group; Y represents an alkylene group or an arylene group; b represents an integer of 0 or 1; and c represents an integer of 0 or 1.
[15] An underlayer film for lithography formed by using the composition for resist underlayer film formation according to any of [1] to [14].
[16] A pattern formation method comprising:
   a resist underlayer film formation step of forming a resist underlayer film on a substrate using the composition for resist underlayer film formation according to any of [1] to [14];
   a photoresist layer formation step of forming at least one photoresist layer on the resist underlayer film; and
   a development step of irradiating a predetermined region of the photoresist layer with radiation for development.
[17] A pattern formation method comprising:
   an organic underlayer film formation step of forming an organic underlayer film on a substrate using a coating type organic under layer film material;
   a resist underlayer film formation step of forming a resist underlayer film on the organic underlayer film using the composition for resist underlayer film formation according to any of [1] to [14];
   an upper layer resist film formation step of forming an upper layer resist film on the resist underlayer film using an upper layer resist film composition;
   an upper layer resist pattern formation step of forming an upper layer resist pattern on the upper layer resist film;
   a resist underlayer film transfer step of transferring the pattern to the resist underlayer film by etching using the upper layer resist pattern as a mask;
   an organic underlayer film transfer step of transferring the pattern to the organic underlayer film by etching using the resist underlayer film to which the pattern is transferred as a mask; and
   a substrate transfer step of transferring the pattern to the substrate by etching using the organic underlayer film to which the pattern is transferred as a mask.
[18] A pattern formation method comprising:
   an organic hard mask formation step of forming an organic hard mask containing carbon as a main component on a substrate by chemical vapor deposition;
   a resist underlayer film formation step of forming a resist underlayer film on the organic hard mask using the composition for resist underlayer film formation according to any of [1] to [14];
   an upper layer resist film formation step of forming an upper layer resist film on the resist underlayer film using an upper layer resist film composition;
   an upper layer resist pattern formation step of forming an upper layer resist pattern on the upper layer resist film;
   a resist underlayer film transfer step of transferring the pattern to the resist underlayer film by etching using the upper layer resist pattern as a mask;
   an organic hard mask transfer step of transferring the pattern to the organic hard mask by etching using the resist underlayer film to which the pattern is transferred as a mask; and
   a substrate transfer step of transferring the pattern to the substrate by etching using the organic hard mask to which the pattern is transferred as a mask.

### Advantageous Effects of Invention

According to the invention, a composition for resist underlayer film formation excellent in pattern formability, an underlayer film for lithography, and a pattern formation method can be provided.

### Description of Embodiments

Hereinafter, an embodiment of the present invention will be described (hereinafter, referred to as the "present embodiment"). Note that the present embodiment is given in order to illustrate the present invention. The present invention is not limited to the present embodiment.

### [Composition for resist underlayer film formation]

The composition for resist underlayer film formation of the present embodiment (hereinafter, simply referred to as the "composition") is a composition for resist underlayer film formation containing a compound represented by the following formula (1) (hereinafter, referred to as the "tellurium containing compound") and a silicon containing compound (for example, a hydrolyzable organosilane, a hydrolysate thereof, or a hydrolysis condensate thereof). Moreover, the composition of the present embodiment is a composition for resist underlayer film formation containing a tellurium containing silicon compound that is a reaction product of the tellurium containing compound and the silicon containing compound. The composition of the present embodiment has a relatively high carbon concentration, a relatively low oxygen concentration, and excellent heat resistance and solubility in a solvent. For these reasons, the composition for resist underlayer film formation is excellent in pattern formability.

[LₓTe(OR¹)_{y}] (1)

wherein, in formula (1), L is a ligand other than OR¹; R¹ is any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, and a substituted or unsubstituted alkynyl group having 2 to 20 carbon atoms; x is an integer of 0 to 6; y is an integer of 0 to 6; the sum of x and y is 1 to 6; when x is 2 or more, a plurality of L may be the same or different; and when y is 2 or more, a plurality of R¹ may be the same or different.

The composition of the present embodiment is used as a material for forming a resist underlayer film in a multi-layer resist. In the multi-layer resist, a resist underlayer film is formed between, for example, an upper layer resist (for example, a photoresist, an electron beam resist, and an EUV resist) and a hard mask or an organic underlayer film. In the production method of such a multi-layer resist, for example, a resist underlayer film is formed on an organic underlayer film or a hard mask on a substrate by a publicly known coating method or the like, and an upper layer resist is formed on the resist underlayer film. Further, in the above production method, a resist pattern is formed by exposure and development, the resist underlayer film is dry-etched by using the resist pattern to transfer the pattern, the pattern is transferred by etching the organic underlayer film, and the substrate is processed by the organic underlayer film.

The resist underlayer film formed by using the composition of the present embodiment hardly causes intermixing with the upper layer resist, has excellent heat resistance, and furthermore, its etching rate to halogen-based (for example, fluorine-based) etching gas is larger than the etching rate in the upper layer resist so that an excellent rectangular pattern can be obtained. Furthermore, the resist underlayer film formed by using the composition of the present embodiment has a high resistance to oxygen-based etching gas and thus can function as a good mask during the patterning of a layer provided on a base material such as a hard mask. Note that the composition of the present embodiment can be applied to a resist layer having a form in which a plurality of resist underlayer films are layered. In this case, the layer position of the resist underlayer film formed by using the composition of the present embodiment is not particularly limited, and may be a position directly below the upper layer resist, a position closest to the substrate side, or a position interposed between two resist underlayer films.

In the formation of a fine pattern, the film thickness of the multi-layer resist tends to be thin to prevent pattern collapse. Due to the multi-layer resist having a thinner film, the dry etching for transferring a pattern on the underlayer film existing as an under layer of the multi-layer resist cannot transfer the pattern unless the etching rate of the underlayer is higher than that of the upper layer film existing as an upper layer of the multi-layer resist. In contrast, by using the resist underlayer film formed by using the composition of the present embodiment, for example, the organic underlayer film formed on the substrate can be coated with the resist underlayer film, and further, the resist underlayer film can be coated with a resist film (organic resist film). An organic component film and an inorganic component film have dry etching rates largely different from each other depending on the selection of the etching gas, such that the organic component film has a high dry etching rate with the use of an oxygen-based gas and the inorganic component film has a high dry etching rate with the use of a halogen containing gas. For example, by using a resist underlayer film onto which a pattern is transferred, an underlying organic underlayer film is dry-etched by an oxygen-based gas to transfer the pattern to the organic underlayer film, and the processing of the substrate can be performed by using a halogen containing gas to the organic underlayer film onto which the pattern is transferred.

The resist underlayer film formed by the composition of the present embodiment contains a tellurium containing compound excellent in active ray absorbing ability and a silicon containing compound (for example, a hydrolyzable organosilane, a hydrolysate thereof, or a hydrolysis condensate thereof), or contains a tellurium containing silicon compound so that the sensitivity of the upper layer resist is improved, the resist underlayer film hardly causes intermixing with the upper layer resist, and the pattern formability of the resist underlayer film after exposure and development is excellent. This enables the processing of a substrate with a fine pattern.

In addition, the resist underlayer film formed by the composition for resist underlayer film formation of the present embodiment has a high heat resistance and thus can be used under high-temperature baking conditions. Moreover, it has a relatively low molecular weight and a low viscosity, and therefore facilitates uniformly and completely filling even the steps of an uneven substrate (particularly having fine space, hole pattern, etc.). For these reasons, when the resist underlayer film is used, there is a tendency that flattening properties or embedding properties can be relatively advantageously increased.

### <Tellurium containing compound>

The tellurium containing compound in the present embodiment is a compound represented by the following formula (1).

[LₓTe(OR¹)_{y}] (1)

In the formula (1), L is a ligand other than OR¹; R¹ is any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, and a substituted or unsubstituted alkynyl group having 2 to 20 carbon atoms; x is an integer of 0 to 6; y is an integer of 0 to 6; the sum of x and y is 1 to 6; when x is 2 or more, a plurality of L may be the same or different; and when y is 2 or more, a plurality of R¹ may be the same or different.

Examples of R¹ include any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, and a substituted or unsubstituted alkynyl group having 2 to 20 carbon atoms. When there are a plurality of R¹, R¹ may be the same as or different from each other.

Specific examples of R¹ include, for example, a methyl group, an ethyl group, a propyl group, a butyl group, a pentyl group, a hexyl group, a heptyl group, an octyl group, a nonyl group, a decyl group, an undecyl group, a dodecyl group, an icosyl group, a cyclopropyl group, a cyclobutyl group, a cyclopentyl group, a cyclohexyl group, a cycloheptyl group, a cyclooctyl group, a cyclononyl group, a cyclodecyl group, a cycloundecyl group, a cyclododecyl group, a cycloicosyl group, a norbornyl group, an adamantyl group, a phenyl group, a naphthyl group, an anthracene group, a pyrenyl group, a biphenyl group, a heptacene group, a vinyl group, a propenyl group, a butenyl group, a pentenyl group, a hexenyl group, an ethynyl group, an allyl group, an icosynyl group and a propargyl group. These groups follow a concept of encompassing isomers, and for example, a butyl group is not limited to a n-butyl group, and may be an isobutyl group, a sec-butyl group or a tert-butyl group. In addition, these groups may have a substituent as long as the number of carbon atoms does not exceed 20, and examples of the substituent include one functional group selected from the group consisting of a carboxyl group, an acryl group and a methacryl group, as well as groups containing these groups.

Among the above, from the viewpoint of etching resistance and solubility, R¹ is preferably a linear alkyl group having 1 to 6 carbon atoms or branched or cyclic alkyl group having 3 to 6 carbon atoms, and is more preferably a linear alkyl group having 1 to 4 carbon atoms or branched or cyclic alkyl group having 3 to 4 carbon atoms. When it has a substituent, that substituent is preferably one or more selected from the group consisting of a carboxyl group, a group containing a carboxyl group, an acrylate group and a methacrylate group, and is more preferably one or more selected from the group consisting of an acrylate group and a methacrylate group.

L is a ligand other than OR¹, and may be a monodentate ligand or a multidentate ligand of a bi- or higher dentate ligand. When there are a plurality of L, L may be the same as or different from each other.

Specific examples of the monodentate ligand include acrylate, methacrylate, amine, chloro, cyano, thiocyano, isothiocyano, nitro, nitrito, triphenylphosphine, pyridine and cyclopentene. Specific examples of the multidentate ligand include, for example, ethylenediamine, acetylacetonato, 2,2-dimethyl-3,5-hexanedione, diethylenetriamine, acrylic acid, methacrylic acid and ethylenediaminetetraacetic acid.

From the viewpoint of flattening properties, L is preferably a multidentate ligand of a bi- or higher dentate ligand, is more preferably any of acetylacetonato, 2,2-dimethyl-3,5-hexanedione, ethylenediamine, diethylenetriamine and methacrylic acid, and is still more preferably any of acetylacetonato, 2,2-dimethyl-3,5-hexanedione and methacrylic acid.

x is an integer of 0 to 6, y is an integer of 0 to 6, and x + y is 1 to 6. From the viewpoint of solubility in a safe solvent, x is preferably an integer of 1 to 6, is more preferably an integer of 1 to 4, and is still more preferably 1 or 2. From the viewpoint of heat resistance, y is preferably an integer of 1 to 6, is more preferably an integer of 1 to 4, and is further preferably an integer of 2 to 4.

The tellurium containing compound is preferably a compound represented by the following formula (1-1), the following formula (1-2) or the following formula (1-3).

[Te(OR¹)₄] (1-1)

(In the formula (1-1), R¹ is as defined in the formula (1).) 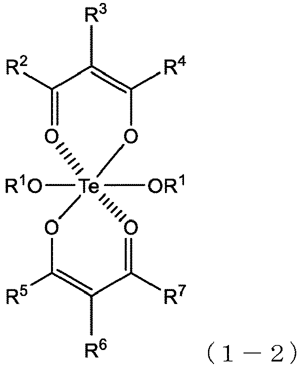 (In the formula (1-2), R¹ is as defined in the formula (1); and R², R³, R⁴, R⁵, R⁶ and R⁷ may be the same or different, and are each independently a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, or a substituted or unsubstituted alkynyl group having 2 to 20 carbon atoms.) 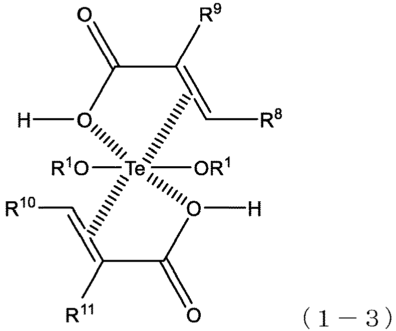 (In the formula (1-3), R¹ is as defined in the formula (1); R⁹ and R¹¹ may be the same or different, and are each independently a hydrogen atom or a methyl group; and R⁸ and R¹⁰ may be the same or different, and are each independently a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, or a substituted or unsubstituted alkynyl group having 2 to 20 carbon atoms.)

Although the tellurium containing compound in the present embodiment is not particularly limited, examples thereof include the following compounds. Among them, a compound represented by the formula (TOX-1), the formula (TOX-2), the formula (TOX-3) or the formula (TOX-4) is preferable.

Te(OEt)₄ (TOX-1)

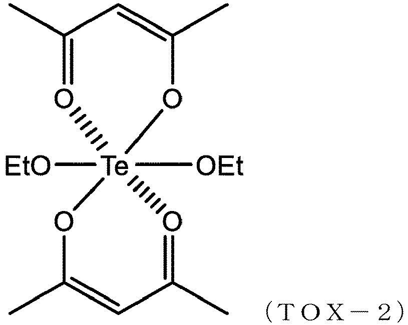

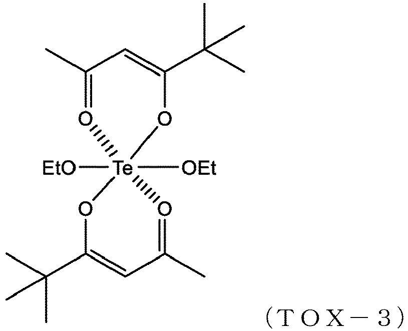

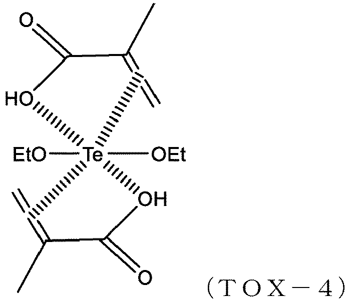

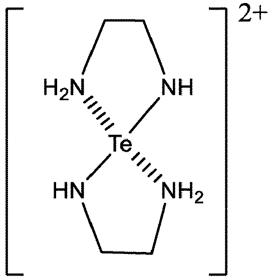

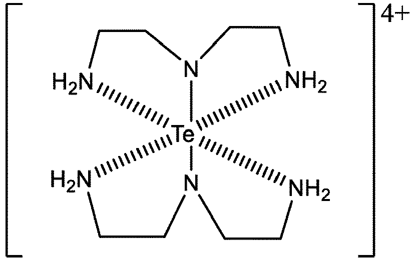

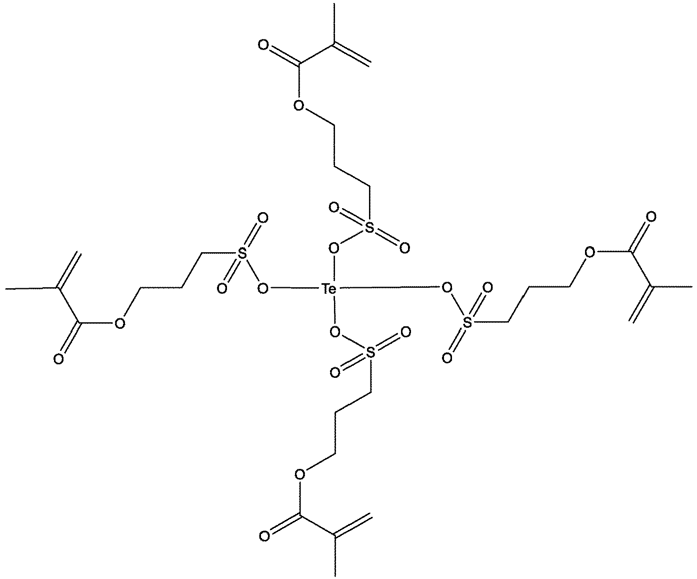

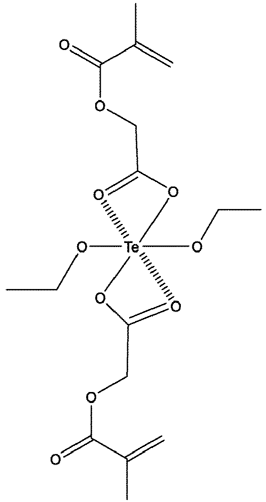

### (Method for producing tellurium containing compound)

The tellurium containing compound of the present embodiment is obtained by, for example, the following method. That is, by heating metal tellurium or tellurium dioxide in a chlorine gas stream to about 500°C, tellurium tetrachloride is obtained. Next, by allowing the obtained tellurium tetrachloride to react with sodium alkoxide under ice cooling with no catalyst, an alkoxy tellurium compound, wherein x is 0 and y is 1 or more in the formula (1), can be obtained. For example, a compound represented by the formula (TOX-1) mentioned above (tetraethoxytellurium(IV)) can be obtained by allowing tellurium tetrachloride to react with ethanol. Alternatively, the tellurium containing compound can be obtained through electrolysis using metal tellurium as the positive electrode.

In the present embodiment, L, which is a ligand other than OR¹, can be obtained by a variety of methods. For example, a tellurium containing compound to which L is coordinated can be obtained by mixing and stirring an alkoxy tellurium compound or metal tellurium dissolved in an organic solvent such as tetrahydrofuran and a ligand L dissolved in an organic solvent such as tetrahydrofuran, and removing the organic solvent. A specific example is shown below. That is, when tetraethoxytellurium(IV) (a compound represented by the formula (TOX-1) mentioned above) is used as an alkoxy tellurium compound, by placing 1.0 g of tetraethoxytellurium(IV) dissolved in 20 mL of tetrahydrofuran in a container with an inner volume of 100 mL equipped with a stirrer, a condenser tube and a burette, further adding 0.5 g of acetylacetone dissolved in 5 mL of tetrahydrofuran, allowing the resultant mixture to reflux for 1 hour, and removing the solvent under reduced pressure, a compound represented by the formula (TOX-2) mentioned above can be obtained.

Moreover, for example, by stirring an aqueous solution of sodium tellurite and a carboxylic acid, a tellurium containing compound to which carboxylate is coordinated is readily produced.

### (Method for purifying tellurium containing compound)

The tellurium containing compound of the present embodiment can be purified by a purification method including the following steps. That is, the purification method includes a step of dissolving the tellurium containing compound in a solvent containing an organic solvent that does not inadvertently mix with water to obtain a solution (A), and a step of bringing the obtained solution (A) into contact with an acidic aqueous solution, thereby extracting impurities in the tellurium containing compound (a first extraction step). According to the purification method of the present embodiment, the contents of various metals that may be contained as impurities in the compound having a specific structure mentioned above can be reduced effectively.

Metals contained in the solution (A) containing the tellurium containing compound are transferred to the aqueous phase, then the organic phase and the aqueous phase are separated, and thus the tellurium containing compound having a reduced metal content can be obtained.

The tellurium containing compound used in the purification method of the present embodiment may be alone, or may be a mixture of two or more kinds. Also, the tellurium containing compound may be applied to the production method of the present embodiment along with a variety of surfactants, a variety of crosslinking agents, a variety of acid generating agents and a variety of stabilizers.

The "organic solvent that does not inadvertently mix with water" used in the purification method of the present embodiment means an organic solvent that is not uniformly mixed with water at an arbitrary ratio. Although such an organic solvent is not particularly limited, it is preferably an organic solvent that is safely applicable to semiconductor production processes. Specifically, it is an organic solvent having a solubility in water at room temperature of less than 30%, more preferably an organic solvent having a solubility of less than 20%, and particularly preferably an organic solvent having solubility of less than 10%. It is preferable that the amount of the organic solvent to be used be 1 to 100 parts by mass based on 100 parts by mass of the tellurium containing compound to be used.

Specific examples of the organic solvent that does not inadvertently mix with water include, but not limited to, an ether such as diethyl ether and diisopropyl ether; an ester such as ethyl acetate, n-butyl acetate and isoamyl acetate; a ketone such as methyl ethyl ketone, methyl isobutyl ketone, ethyl isobutyl ketone, cyclohexanone (CHN), cyclopentanone, 2-heptanone and 2-pentanone; a glycol ether acetate such as ethylene glycol monoethyl ether acetate, ethylene glycol monobutyl ether acetate, propylene glycol monomethyl ether acetate (PGMEA) and propylene glycol monoethyl ether acetate; an aliphatic hydrocarbon such as n-hexane and n-heptane; an aromatic hydrocarbon such as toluene and xylene; and a halogenated hydrocarbon such as methylene chloride and chloroform. Among the above, one or more organic solvents selected from the group consisting of toluene, 2-heptanone, cyclohexanone, cyclopentanone, methyl isobutyl ketone, propylene glycol monomethyl ether acetate, ethyl acetate and the like are preferable, methyl isobutyl ketone, ethyl acetate, cyclohexanone and propylene glycol monomethyl ether acetate are more preferable, and methyl isobutyl ketone and ethyl acetate are still more preferable. Methyl isobutyl ketone, ethyl acetate and the like have relatively high saturation solubility for the tellurium containing compound and a relatively low boiling point, and it is thus possible to reduce the load in the case of industrially distilling off the solvent and in the step of removing the solvent by drying.

These organic solvents can be each used alone, or can also be used as a mixture of two or more kinds.

The acidic aqueous solution used in the purification method of the present embodiment is arbitrarily selected from among aqueous solutions in which organic compounds or inorganic compounds are dissolved in water, generally known as acidic aqueous solutions. Examples of the acidic aqueous solution include, but not limited to, an aqueous mineral acid solution in which a mineral acid, such as hydrochloric acid, sulfuric acid, nitric acid and phosphoric acid, is dissolved in water; and an aqueous organic acid solution in which an organic acid, such as acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid, is dissolved in water. These acidic aqueous solutions can be each used alone, or can also be used as a combination of two or more kinds. Among these acidic aqueous solutions, aqueous solutions of one or more mineral acids selected from the group consisting of hydrochloric acid, sulfuric acid, nitric acid and phosphoric acid, or aqueous solutions of one or more organic acids selected from the group consisting of acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid are preferable, aqueous solutions of sulfuric acid, nitric acid, and carboxylic acids such as acetic acid, oxalic acid, tartaric acid and citric acid are more preferable, aqueous solutions of sulfuric acid, oxalic acid, tartaric acid and citric acid are still more preferable, and an aqueous solution of oxalic acid is even more preferable. It is considered that polyvalent carboxylic acids such as oxalic acid, tartaric acid and citric acid coordinate with metal ions and provide a chelating effect, and thus tend to be capable of more effectively removing metals. Also, as for water used herein, it is preferable to use water, the metal content of which is small, such as ion exchanged water, according to the purpose of the purification method of the present embodiment.

The pH of the acidic aqueous solution to be used in the purification method of the present embodiment is not particularly limited, but it is preferable to regulate the acidity of the aqueous solution in consideration of an influence on the tellurium containing compound. Normally, the pH range of the acidic aqueous solution is about 0 to 5, and is preferably about 0 to 3.

The amount of the acidic aqueous solution to be used in the purification method of the present embodiment is not particularly limited, but it is preferable to regulate the amount to be used from the viewpoint of reducing the number of extraction operations for removing metals and from the viewpoint of ensuring operability in consideration of the overall amount of fluid. From the above viewpoints, the amount of the acidic aqueous solution used is preferably 10 to 200 parts by mass, and more preferably 20 to 100 parts by mass, based on 100 parts by mass of the solution (A).

In the purification method of the present embodiment, by bringing an acidic aqueous solution as described above into contact with the solution (A) containing one or more selected from the tellurium containing compounds mentioned above and the organic solvent that does not inadvertently mix with water, metals can be extracted from the compounds in the solution (A).

When the solution (A) contains an organic solvent that inadvertently mixes with water, there is a tendency that the amount of the tellurium containing compound to be charged can be increased, also the fluid separability is improved, and purification can be carried out at a high reaction vessel efficiency. The method for adding the organic solvent that inadvertently mixes with water is not particularly limited. For example, any of a method involving adding it to the organic solvent-containing solution in advance, a method involving adding it to water or the acidic aqueous solution in advance, and a method involving adding it after bringing the organic solvent-containing solution into contact with water or the acidic aqueous solution may be employed. Among the above, the method involving adding it to the organic solvent-containing solution in advance is preferable in terms of the workability of operations and the ease of managing the amount to be charged.

The organic solvent that inadvertently mixes with water to be used in the purification method of the present embodiment is not particularly limited, but is preferably an organic solvent that is safely applicable to semiconductor production processes. The amount of the organic solvent that inadvertently mixes with water to be used is not particularly limited as long as the solution phase and the aqueous phase separate, but is preferably 0.1 to 100 parts by mass, more preferably 0.1 to 50 parts by mass, and still more preferably 0.1 to 20 parts by mass based on 100 parts by mass of the tellurium containing compound.

Specific examples of the organic solvent that inadvertently mixes with water to be used in the purification method of the present embodiment include, but not limited to, an ether such as tetrahydrofuran and 1,3-dioxolane; an alcohol such as methanol, ethanol and isopropanol; a ketone such as acetone and N-methylpyrrolidone; and an aliphatic hydrocarbon such as a glycol ether such as ethylene glycol monoethyl ether, ethylene glycol monobutyl ether, propylene glycol monomethyl ether (PGME) and propylene glycol monoethyl ether. Among the above, N-methylpyrrolidone, propylene glycol monomethyl ether and the like are preferable, and N-methylpyrrolidone and propylene glycol monomethyl ether are more preferable. These solvents can be each used alone, or can also be used as a mixture of two or more kinds.

In the purification method of the present embodiment, the temperature when the solution (A) and the acidic aqueous solution are brought into contact, that is, when extraction treatment is carried out, is preferably in the range of 20 to 90°C, and more preferably 30 to 80°C. The extraction operation is not particularly limited, and is carried out by, for example, thoroughly mixing the solution (A) and the acidic aqueous solution by stirring or the like and then leaving the obtained mixed solution to stand still. Thereby, metals contained in the solution (A) containing one or more selected from the tellurium containing compounds and the organic solvents are transferred to the aqueous phase. Also, by this operation, the acidity of the solution (A) is lowered, and the deterioration of the tellurium containing compound can be suppressed.

By leaving the mixed solution to stand still, it is separated into an aqueous phase and a solution phase containing one or more selected from the tellurium containing compounds and the organic solvents, and thus the solution phase containing one or more selected from the tellurium containing compounds and the organic solvents can be recovered by decantation or the like. The time for leaving the mixed solution to stand still is not particularly limited, but it is preferable to regulate the time for leaving the mixed solution to stand still from the viewpoint of attaining better separation of the solution phase containing the organic solvents and the aqueous phase. Normally, the time for leaving the mixed solution to stand still is 1 minute or longer, preferably 10 minutes or longer, and still more preferably 30 minutes or longer. While the extraction treatment may be carried out only once, it is also effective to repeat mixing, leaving-to-stand-still, and separating operations multiple times.

It is preferable that the purification method of the present embodiment include a step of further bringing the solution phase containing the compound into contact with water after the first extraction step, thereby extracting impurities in the compound (a second extraction step). Specifically, for example, it is preferable that, after the extraction treatment is carried out using an acidic aqueous solution, the solution phase that is extracted and recovered from the aqueous solution and that contains one or more selected from the tellurium containing compounds and the organic solvents be further subjected to extraction treatment with water. The extraction treatment with water is not particularly limited, and can be carried out by, for example, thoroughly mixing the solution phase and water by stirring or the like and then leaving the obtained mixed solution to stand still. The mixed solution after being left to stand still is separated into an aqueous phase and a solution phase containing one or more selected from the tellurium containing compounds and the organic solvents, and thus the solution phase containing one or more selected from the tellurium containing compounds and the organic solvents can be recovered by decantation or the like.

Also, water used herein is preferably water, the metal content of which is small, such as ion exchanged water, according to the purpose of the present embodiment. While the extraction treatment may be carried out only once, it is also effective to repeat mixing, leaving-to-stand-still, and separating operations multiple times. In addition, the proportions of both used in the extraction treatment, and temperature, time and other conditions are not particularly limited, and may be the same as those of the previous contact treatment with the acidic aqueous solution.

Water that is possibly present in the thus obtained solution containing one or more selected from the tellurium containing compounds and the organic solvents can be readily removed by performing vacuum distillation or a like operation. Also, if required, the concentration of the tellurium containing compound can be regulated to be any concentration by adding an organic solvent to the solution.

The method for isolating the one or more selected from the compounds represented by the formula (1) from the obtained solution containing one or more selected from the compounds represented by the formula (1) and the organic solvents is not particularly limited, and publicly known methods can be carried out, such as reduced-pressure removal, separation by reprecipitation, and a combination thereof. A publicly known treatment such as concentration operation, filtration operation, centrifugation operation and drying operation can be carried out, if required.

### <Silicon containing compound>

The composition of the present embodiment contains a silicon containing compound in combination with the tellurium containing compound, and the like. The silicon containing compound may be either an organic silicon containing compound or an inorganic silicon containing compound, but is preferably an organic silicon containing compound. Examples of the inorganic silicon containing compound include, for example, a polysilazane compound made of silicon oxide, silicon nitride, and silicon oxynitride capable of forming a film by a low temperature coating method. In addition, examples of the organic silicon containing compound include, for example, a polysilsesquioxane-based compound, a hydrolyzable organosilane, and a hydrolysate thereof or a hydrolysis condensate thereof. A specific material for the polysilsesquioxane-based compound is not limited, and, for example, a material described in Japanese Patent Laid-Open No. 2007-226170 or Japanese Patent Laid-Open No. 2007-226204 can be used.

The silicon containing compound is preferably a hydrolyzable organosilane, a hydrolysate thereof, or a hydrolysis condensate thereof, and more preferably at least one hydrolyzable organosilane selected from the group consisting of a compound represented by the following formula (D1), a compound represented by (D2), and a compound represented by (D3), a hydrolysate thereof, or a hydrolysis condensate thereof (hereinafter, also referred to as the "specific organosilicon compound"). When the silicon containing compound is the specific organosilicon compound, the Si-O bond can be easily formed by regulating the curing conditions while possessing organic groups, and thus is suitable to introduce organic components.

(R³)ₐSi(R⁴)₄₋ₐ... (D1)

(In the formula (D1), R³ represents an alkyl group, an aryl group, an aralkyl group, a halogenated alkyl group, a halogenated aryl group, a halogenated aralkyl group, an alkenyl group, an epoxy group, an acryloyl group, a methacryloyl group, an alkoxyaryl group, an acyloxyaryl group, or a cyano group, or a group obtained by combining two or more of these groups, which groups optionally have a mercapto group, an isocyanurate group, a hydroxy group, or cyclic amino group as a substituent; R⁴ represents an alkoxy group, an acyloxy group, or a halogen group; and a represents an integer of 0 to 3.)

[(R⁵)_{c}Si(R⁶)_{4-c}]₂Y... (D2)

(R⁵)_{c}Si(R⁶)_{4-c}... (D3)

(In the formula (D2) and (D3), R⁵ represents an alkyl group; R⁶ represents an alkoxy group, an acyloxy group, or a halogen group; Y represents an alkylene group or an arylene group; b represents an integer of 0 or 1; and c represents an integer of 0 or 1.)

In the composition for resist underlayer film formation, the ratio of the tellurium containing compound and the silicon containing compound (for example, a specific organosilicon compound) is, for example, in the range of 1:2 to 1:200 (former:latter) in terms of mole ratio. From the viewpoint of obtaining a good resist shape, the ratio is preferably in the range of 1:2 to 1:100 (former:latter) in terms of mole ratio. The specific organosilicon compound is preferably in the form of a hydrolysis condensate (polyorganosiloxane polymer).

Examples of the hydrolyzable organosilane represented by the formula (D1) include, for example, tetramethoxysilane, tetrachlorosilane, tetraacetoxysilane, tetraethoxysilane, tetra n-propoxysilane, tetraisopropoxysilane, tetra n-butoxysilane, methyltrimethoxysilane, methyltriethoxysilane, methyltrichlorosilane, methyltriacetoxysilane, methyltripropoxysilane, methyltriacetyloxysilane, methyltributoxysilane, methyltriamyloxysilane, methyltriphenoxysilane, methyltribenzyloxysilane, methyltriphenetyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltrichlorosilane, vinyltriacetoxysilane, vinyltriethoxysilane, phenyltrimethoxysilane, phenyltrichlorosilane, phenyltriacetoxysilane, phenyltriethoxysilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, chloromethyltrimethoxysilane, chloromethyltriethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, methylvinyldiethoxysilane, phenylsulfonylaminopropyltriethoxysilane, methylsulfonylaminopropyltriethoxysilane, phenylsulfonylaminopropyltrimethoxysilane, and methylsulfonylaminopropyltrimethoxysilane. These hydrolyzable organosilanes are used alone as one kind or in combination of two or more kinds.

The hydrolyzable organosilane represented by the formula (D1) is particularly preferably a combination of tetraalkoxysilane such as tetramethoxysilane and tetraethoxysilane, and phenyltrialkoxysilane such as phenyltrimethoxysilane and phenyltriethoxysilane. Furthermore, it is preferable that alkyltrialkoxysilane such as methyltrimethoxysilane and methyltriethoxysilane be combined with the combination thereof.

Examples of the hydrolyzable organosilane represented by the formula (D2) or (D3) include, for example, methylenebistrimethoxysilane, methylenebistrichlorosilane, methylenebistriacetoxysilane, ethylenebistriethoxysilane, ethylenebistrichlorosilane, ethylenebistriacetoxysilane, propylenebistriethoxysilane, butylenebistrimethoxysilane, phenylenebistrimethoxysilane, phenylenebistriethoxysilane, phenylenebismethyldiethoxysilane, phenylenebismethyldimethoxysilane, naphthylenebistrimethoxysilane, bistrimethoxydisilane, bistriethoxydisilane, bisethyldiethoxydisilane, and bismethyldimethoxydisilane. These hydrolyzable organosilanes are used alone as one kind or in combination of two or more kinds.

In the composition for resist underlayer film formation of the present embodiment, the tellurium containing compound and the silicon containing compound may exist in the form of an unreacted mixture in which the tellurium containing compound and the silicon containing compound are not reacted with each other, or may be exist in the form of a tellurium containing silicon compound which is obtained by reacting the tellurium containing compound with the silicon containing compound.

### <Tellurium containing silicon compound>

For example, the tellurium containing silicon compound is obtained by reacting the tellurium containing compound with the silicon containing compound.

Examples of the reaction include carrying out the hydrolytic condensation of the tellurium containing compound with a hydrolyzable organosilane and the like using an acid catalyst (for example, one or more compounds selected from an inorganic acid, an aliphatic sulfonic acid, and an aromatic sulfonic acid).

The mole ratio of the tellurium containing compound to the silicon containing compound to be reacted [tellurium containing compound/silicon containing compound] is preferably 1/99 to 80/20, more preferably 3/97 to 50/50, further preferably 5/95 to 20/80.

Examples of the acid catalyst include an inorganic acid such as hydrofluoric acid, hydrochloric acid, hydrobromic acid, sulfuric acid, nitric acid, perchloric acid, phosphoric acid; an aliphatic sulfonic acid such as methanesulfonic acid; and an aromatic sulfonic acid such as benzenesulfonic acid and toluenesulfonic acid. The amount of the catalyst to be used is preferably 10⁻⁶ to 10 mol, more preferably 10⁻⁵ to 5 mol, and further preferably 10⁻⁴ to 1 mol based on 1 mol of the total amount of the tellurium containing compound and the silicon containing compound.

When the tellurium containing silicon compound is obtained by the hydrolytic condensation of the tellurium containing compound and the silicon containing compound described above, water may be added thereto. The amount of water to be added is preferably 0.01 to 100 mol, more preferably 0.05 to 50 mol, and further preferably 0.1 to 30 mol based on 1 mol of the hydrolyzable substituent bonded to the tellurium containing compound and the silicon containing compound described above. When the amount of water to be added is 100 mol or less, the apparatus to be used in the reaction is not too large and thus it is economical.

As an operation method for synthesizing the tellurium containing silicon compound, for example, a tellurium containing compound and a silicon containing compound are added to an aqueous catalyst solution to initiate the hydrolysis condensation reaction. At this time, an organic solvent may be added to the catalyst aqueous solution, or the tellurium containing compound and the silicon containing compound may be diluted with an organic solvent, or both procedures may be performed. The reaction temperature is preferably 0 to 100°C, and more preferably 40 to 100°C. A method in which the temperature is maintained at 5 to 80°C when the tellurium containing compound and the silicon containing compound are added dropwise, and then the mixture is matured at 40 to 100°C is preferable.

Examples of the above organic solvent include, for example, methanol, ethanol, 1-propanol, 2-propanol, 1-butanol, 2-butanol, 2-methyl-1-propanol, acetone, acetonitrile, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, 3-methyl methoxy propionate, 3-ethoxy ethyl propionate, tert-butyl acetate, t-butyl propionate, propylene glycol mono t-butyl ether acetate, γ-butyrolactone, and a mixture thereof.

Among these organic solvents, water-soluble organic solvents are more preferable, and examples of the water-soluble organic solvent include, for example, an alcohol such as methanol, ethanol, 1-propanol, and 2-propanol; a polyhydric alcohol such as ethylene glycol and propyleneglycol; a polyhydric alcohol condensate derivative such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone, acetonitrile, and tetrahydrofuran. Among them, a water-soluble organic solvent having a boiling point of 100°C or less is particularly preferable.

The amount of the organic solvent used is preferably 0 to 1,000 ml, and particularly preferably 0 to 500 ml based on 1 mol of the above monomer. When the amount of the organic solvent used is 1,000 ml or less, the reaction vessel is not too large and thus it is economical.

Thereafter, if required, the neutralization reaction of the catalyst is performed, the alcohol produced in the hydrolysis condensation reaction is removed under reduced pressure to obtain an aqueous reaction mixture solution. At this time, the amount of alkaline substance that can be used in the neutralization is preferably 0.1 to 2 equivalents based on the acid used as the catalyst. Any alkaline substance can be used as long as it exhibits alkalinity in water.

Subsequently, by-products such as alcohol produced from the reaction mixture in the hydrolysis condensation reaction are preferably removed. At this time, the temperature for heating the reaction mixture is preferably 0 to 100°C, more preferably 10 to 90°C, and further preferably 15 to 80°C, although the temperature depends on the kinds of the organic solvent added, alcohols and the like produced by the reaction. At this time, the degree of vacuum is preferably atmospheric pressure or less, more preferably 80 kPa or less in the absolute pressure, further preferably 50 kPa or less in the absolute pressure, although it varies depending on the kinds of the organic solvent, alcohol, and the like to be removed, exhaust apparatus, condensing apparatus, and heating temperature. It is difficult to know the precise amount of the alcohol to be removed at this time, but it is desired to remove about 80% by mass or more of the alcohol produced.

Then, the acid catalyst used in the hydrolytic condensation may be removed from the reaction mixture. The method for removing the acid catalyst can be exemplified by a method for mixing water and the tellurium containing silicon compound and then extracting the tellurium containing silicon compound with an organic solvent. As an organic solvent to be used at this time, an organic solvent that can dissolve the tellurium containing silicon compound and can separate into two layers when mixed with water is preferable. Examples thereof can include, for example, 1-butanol, 2-butanol, 2-methyl-1-propanol, toluene, hexane, ethyl acetate, cyclohexanone, methyl amyl ketone, butanediol monomethyl ether, butanediol monoethyl ether, ethylene glycol diethyl ether, butanediol monopropyl ether, propylene glycol monomethyl ether acetate, propylene glycol monoethyl ether acetate, ethyl pyruvate, butyl acetate, 3-methyl methoxy propionate, 3-ethoxy ethyl propionate, t-butyl acetate, t-butyl propionate, propylene glycol mono t-butyl ether acetate, methyl isobutyl ketone, cyclopentyl methyl ether, and a mixture thereof.

Furthermore, when the acid catalyst used in the hydrolytic condensation is removed from the reaction mixture, a mixture of a water-soluble organic solvent and a poorly water-soluble organic solvent can also be used. For example, a combination such as a mixture of methanol and ethyl acetate, a mixture of ethanol and ethyl acetate, a mixture of 1-propanol and ethyl acetate, a mixture of 2-propanol and ethyl acetate, a mixture of butanediol monomethyl ether and ethyl acetate, a mixture of propylene glycol monomethyl ether and ethyl acetate, a mixture of ethylene glycol monomethyl ether and ethyl acetate, a mixture of butanediol monoethyl ether and ethyl acetate, a mixture of propylene glycol monoethyl ether and ethyl acetate, a mixture of ethylene glycol monoethyl ether and ethyl acetate, a mixture of butanediol monopropyl ether and ethyl acetate, a mixture of propylene glycol monopropyl ether and ethyl acetate, a mixture of ethylene glycol monopropyl ether and ethyl acetate, a mixture of methanol and methyl isobutyl ketone, a mixture of ethanol and methyl isobutyl ketone, a mixture of 1-propanol and methyl isobutyl ketone, a mixture of 2-propanol and methyl isobutyl ketone, a mixture of propylene glycol monomethyl ether and methyl isobutyl ketone, a mixture of ethylene glycol monomethyl ether and methyl isobutyl ketone, a mixture of propylene glycol monoethyl ether and methyl isobutyl ketone, a mixture of ethylene glycol monoethyl ether and methyl isobutyl ketone, propylene glycol monopropyl ether + methyl isobutyl ketone, a mixture of ethylene glycol monopropyl ether and methyl isobutyl ketone, a mixture of methanol and cyclopentyl methyl ether, a mixture of ethanol and cyclopentyl methyl ether, a mixture of 1-propanol and cyclopentyl methyl ether, a mixture of 2-propanol and cyclopentyl methyl ether, a mixture of propylene glycol monomethyl ether and cyclopentyl methyl ether, a mixture of ethylene glycol monomethyl ether and cyclopentyl methyl ether, a mixture of propylene glycol monoethyl ether and cyclopentyl methyl ether, a mixture of ethylene glycol monoethyl ether and cyclopentyl methyl ether, a mixture of propylene glycol monopropyl ether and cyclopentyl methyl ether, a mixture of ethylene glycol monopropyl ether and cyclopentyl methyl ether, a mixture of methanol and propylene glycol methyl ether acetate, a mixture of ethanol and propylene glycol methyl ether acetate, a mixture of 1-propanol and propylene glycol methyl ether acetate, a mixture of 2-propanol and propylene glycol methyl ether acetate, a mixture of propylene glycol monomethyl ether and propylene glycol methyl ether acetate, a mixture of ethylene glycol monomethyl ether and propyleneglycol methyl ether acetate, a mixture of propylene glycol monoethyl ether and propylene glycol methyl ether acetate, a mixture of ethylene glycol monoethyl ether and propylene glycol methyl ether acetate, a mixture of propylene glycol monopropyl ether and propylene glycol methyl ether acetate, and a mixture of ethylene glycol monopropyl ether and propylene glycol methyl ether acetate are preferable, but the combination is not limited thereto.

Note that the mixing ratio of the water-soluble organic solvent to the poorly water-soluble organic solvent is arbitrarily selected and the water-soluble organic solvent is preferably 0.1 to 1,000 parts by mass, more preferably 1 to 500 parts by mass, and further preferably 2 to 100 parts by mass based on 100 parts by mass of the poorly water-soluble organic solvent.

In both cases of the tellurium containing silicon compound in which the acid catalyst remains and the tellurium containing silicon compound from which the acid catalyst is removed, a tellurium containing silicon compound solution can be obtained by adding a final solvent and carrying out solvent exchange under reduced pressure. At this time, the temperature of the solvent exchange is preferably 0 to 100°C, more preferably 10 to 90°C, and further preferably 15 to 80°C, although it depends on the kinds of the reaction solvent to be removed and the extraction solvent. At this time, the degree of vacuum is preferably atmospheric pressure or less, more preferably 80 kPa or less in the absolute pressure, further preferably 50 kPa or less in the absolute pressure, although it varies depending on the kinds of the extraction solvent to be removed, exhaust apparatus, condensing apparatus, or heating temperature.

The composition for resist underlayer film formation of the present embodiment may further contain, as an optional component, one or more selected from the group consisting of a solvent, an acid crosslinking agent, an acid generating agent, an acid diffusion controlling agent, and a basic compound.

The content of the tellurium containing compound is preferably 0.1 to 70% by mass, more preferably 0.5 to 50% by mass, further preferably 3.0 to 40% by mass, and still more preferably 10 to 30% by mass based on the total solid content (100% by mass) of the composition of the present embodiment.

The content of the tellurium containing compound in the composition of the present embodiment is preferably 0.1 to 30% by mass, more preferably 0.5 to 15% by mass, and still more preferably 1.0 to 10% by mass based on the entire mass of the composition for resist underlayer film formation, from the viewpoint of coatability and quality stability.

The content of the tellurium containing silicon compound is preferably 10 to 100% by mass, more preferably 50 to 100% by mass, further preferably 70 to 100% by mass, and still more preferably 10 to 30% by mass based on the total solid content (100% by mass) of the composition of the present embodiment.

The content of the tellurium containing silicon compound in the composition of the present embodiment is preferably 0.1 to 30% by mass, more preferably 0.5 to 15% by mass, and still more preferably 1.0 to 10% by mass based on the entire mass of the composition for resist underlayer film formation, from the viewpoint of coatability and quality stability.

### <Solvent>

Examples of the solvent include a solvent capable of dissolving at least the tellurium containing compound.

Specific examples of the solvent include, but not particularly limited to: ketone-based solvents such as acetone, methyl ethyl ketone, methyl isobutyl ketone, and cyclohexanone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, ethyl lactate, methyl methoxypropionate, and methyl hydroxyisobutyrate; alcohol-based solvents such as methanol, ethanol, isopropanol, and 1-ethoxy-2-propanol; and aromatic hydrocarbons such as toluene, xylene, and anisole. These organic solvents are used alone as one kind or in combination of two or more kinds.

Among the above, the solvent is particularly preferably cyclohexanone, propylene glycol monomethyl ether, propylene glycol monomethyl ether acetate, ethyl lactate, methyl hydroxyisobutyrate, 1-methoxy-2-propanol, or anisole, from the viewpoint of safety.

The content of the solvent is not particularly limited and is preferably 100 to 10,000 parts by mass, more preferably 200 to 5,000 parts by mass, and still more preferably 200 to 1,000 parts by mass based on 100 parts by mass of the total solid content of the composition for resist underlayer film formation, from the viewpoint of solubility and film formation.

### <Acid crosslinking agent>

It is preferable that the composition for resist underlayer film formation of the present embodiment contain an acid crosslinking agent, from the viewpoint of, for example, suppressing intermixing. Examples of the acid crosslinking agent include, for example, a melamine compound, an epoxy compound, a guanamine compound, a glycoluril compound, a urea compound, a thioepoxy compound, an isocyanate compound, an azide compound, and a compound containing a double bond such as alkenyl ether group, and these compounds may have at least one group selected from a methylol group, an alkoxymethyl group, and an acyloxymethyl group as a substituent (crosslinking group). Note that these acid crosslinking agents are used alone as one kind or in combination of two or more kinds.

Specific examples of the acid crosslinking agent include, for example, those described in International Publication No. WO 2013/024779.

In the composition of the present embodiment, the content of the acid crosslinking agent is not particularly limited and is preferably 5 to 50 parts by mass, and more preferably 10 to 40 parts by mass based on 100 parts by mass of the total solid content of the composition for resist underlayer film formation. By setting the content to the above range, occurrence of a mixing event with a resist layer tends to be suppressed. Also, an antireflection effect is enhanced, and crosslinking film formability tends to be enhanced.

### <Acid generating agent>

It is preferable that the composition of the present embodiment contain an acid generating agent from the viewpoint of, for example, further accelerating crosslinking reaction by heat. The acid generating agent may be a compound that generates acid by thermal decomposition, or may be a compound that generates acid by irradiation of light. Examples of the acid generating agent include, for example, compounds described in International Publication No. WO 2013/024779.

In the composition of the present embodiment, the content of the acid generating agent is not particularly limited and is preferably 0.1 to 50 parts by mass, and more preferably 0.5 to 40 parts by mass based on 100 parts by mass of the total solid content of the composition for resist underlayer film formation. By setting the content to the above range, crosslinking reaction tends to be enhanced by an increased amount of an acid generated. Also, occurrence of a mixing event with a resist layer tends to be suppressed.

### <Acid diffusion controlling agent>

It is preferable that the composition of the present embodiment contain an acid diffusion controlling agent from the viewpoint of controlling diffusion of the acid generated from the acid generating agent by radiation irradiation in a resist film to inhibit any unpreferable chemical reaction in an unexposed region. By allowing the composition of the present embodiment to contain an acid diffusion controlling agent, the storage stability of the composition tends to be further improved. In addition, along with even further improvement in the resolution, the line width change of a resist pattern due to variation in the post exposure delay time before radiation irradiation and the post exposure delay time after radiation irradiation can be inhibited even more, and the composition tends to have even more excellent process stability.

The acid diffusion controlling agent contains, for example, a radiation degradable basic compound such as a nitrogen atom containing basic compound, a basic sulfonium compound and a basic iodonium compound. More specifically, examples of the radiation degradable basic compound include compounds described in paragraphs 0128 to 0141 of International Publication No. WO 2013/024778. These radiation degradable basic compounds can be used alone as one kind or used in combination of two or more kinds.

The content of the acid diffusion controlling agent in the composition of the present embodiment is preferably 0.1 to 50 parts by mass, and more preferably 0.5 to 40 parts by mass based on 100 parts by mass of the solid fraction. By setting the content to the above range, the chemical reaction tends to properly progress.

### <Dissolution controlling agent>

The composition of the present embodiment may contain a dissolution controlling agent. The dissolution controlling agent is a component having a function of, when the solubility of the tellurium containing compound in a developing solution is too high, controlling the solubility of the compound to moderately decrease the dissolution rate upon developing. As such a dissolution controlling agent, the one which does not chemically change in steps such as calcination of optical component, heating and development is preferable.

The dissolution controlling agent is not particularly limited, and examples thereof can include an aromatic hydrocarbon such as phenanthrene, anthracene and acenaphthene; a ketone such as acetophenone, benzophenone and phenyl naphthyl ketone; and a sulfone such as methyl phenyl sulfone, diphenyl sulfone and dinaphthyl sulfone. These dissolution controlling agents can be used alone, or can be used in combination of two or more kinds.

The content of the dissolution controlling agent is not particularly limited, and is arbitrarily adjusted depending on the type of the tellurium containing compound to be used. However, it is preferably 0 to 49% by mass of the entire mass of the solid components, and particularly preferably 0% by mass. When the dissolution controlling agent is contained, the content thereof is more preferably 0.1 to 5% by mass, and further preferably 0.5 to 1% by mass.

### <Sensitizing agent>

The composition of the present embodiment may contain a sensitizing agent. The sensitizing agent is a component having a function of absorbing irradiated radiation energy, transmitting the energy to the acid generating agent (C), and thereby increasing the acid production amount, and improving the apparent curability of the resist underlayer film forming composition. Such a sensitizing agent is not particularly limited, and examples thereof can include a benzophenone, a biacetyl, a pyrene, a phenothiazine and a fluorene. These sensitizing agents can be used alone, or can be used in combination of two or more kinds. The content of the sensitizing agent is arbitrarily adjusted depending on the type of the tellurium containing compound to be used. However, it is preferably 0 to 49% by mass of the entire mass of the solid components, and particularly preferably 0% by mass. When the sensitizing agent is contained, the content thereof is more preferably 0.1 to 5% by mass, and further preferably 0.5 to 1% by mass.

### <Polymerization initiator>

It is preferable that the composition of the present embodiment contain a polymerization initiator, from the viewpoint of improving the curability. The polymerization initiator is not limited as long as it initiates, by exposure, the polymerization reaction of the tellurium containing compound, the silicon compound, or the tellurium containing silicon compound, a publicly known polymerization initiator can be contained. Examples of the polymerization initiator can include, but not limited to, a photoradical polymerization initiator, a photocationic polymerization initiator, and a photoanionic polymerization initiator, and from the viewpoint of reactivity, a photoradical polymerization initiator is preferable.

Examples of the photo-radical polymerization initiator can include, but not limited to, alkylphenone-based, acylphosphine oxide-based, and oxyphenylacetic acid ester-based initiators. From the viewpoint of reactivity, alkylphenone-based initiators are preferable, and from the viewpoint of easy availability, 1-hydroxycyclohexyl phenyl ketone (product name: IRGACURE 184 from BASF SE), 2,2-dimethoxy-2-phenylacetophenone (product name: IRGACURE 651 from BASF SE), and 2-hydroxy-2-methyl-1-phenylpropanone (product name: IRGACURE 1173 from BASF SE) are preferable.

In the composition of the present embodiment, the content of the polymerization initiator is preferably 0.1 to 20 parts by mass, more preferably 0.3 to 20 parts by mass, and still more preferably 0.5 to 10 parts by mass based on 100 parts by mass of the entire mass of the tellurium containing compound, the silicon compound, and the tellurium containing silicon compound.

### <Basic compound>

It is preferable that the composition of the present embodiment contain a basic compound, from the viewpoint of, for example, improving the storage stability and the like.

The basic compound plays a role as a quencher against acids in order to prevent crosslinking reaction from proceeding due to a trace amount of an acid generated by the acid generating agent. Examples of such a basic compound include primary, secondary or tertiary aliphatic amines, amine blends, aromatic amines, heterocyclic amines, nitrogen-containing compounds having a carboxyl group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, and imide derivatives. Specific examples of the basic compound include, for example, compounds described in International Publication No. WO 2013/024779.

In the composition of the present embodiment, the content of the basic compound is not particularly limited and is preferably 0.001 to 2 parts by mass, and more preferably 0.01 to 1 part by mass based on 100 parts by mass of the total solid content of the composition for resist underlayer film formation. By setting the content to the above range, storage stability tends to be enhanced without excessively deteriorating crosslinking reaction.

### <Additional optional component>

The composition for resist underlayer film formation can contain, if necessary, an organic polymeric compound, a crosslinking agent, a photoacid generating agent, a surfactant, and the like in addition to the above-described components.

By using the organic polymeric compound, the dry etching rate (the reduced amount of the film thickness per unit time), the extinction coefficient, the refractive index, and the like of the resist underlayer film formed from the composition for resist underlayer film formation can be regulated.

The organic polymeric compound is not particularly limited and various organic polymers can be used. A condensation polymerization polymer, an addition polymerization polymer, and the like can be used. An addition polymerization polymer and a condensation polymerization polymer such as polyester, polystyrene, polyimide, acrylic polymer, methacrylic polymer, polyvinyl ether, phenol novolac, naphthol novolac, polyether, polyamide, and polycarbonate can be used. An organic polymer having an aromatic ring structure functioning as a light-absorbing moiety such as a benzene ring, a naphthalene ring, an anthracene ring, a triazine ring, a quinoline ring, and a quinoxaline ring is preferably used.

By using the crosslinking agent, the dry etching rate (the reduced amount of the film thickness per unit time), and the like of the resist underlayer film formed from the composition of the present embodiment can be regulated.

The crosslinking agent is not particularly limited and various crosslinking agents can be used. Specific examples of the crosslinking agent usable in the present embodiment include, for example, a melamine compound, a guanamine compound, a glycoluril compound, a urea compound, an epoxy compounds, a thioepoxy compounds, an isocyanate compound, an azide compound, and a compound containing a double bond such as alkenyl ether group, which have at least one group selected from a methylol group, an alkoxymethyl group, and an acyloxymethyl group as a substituent (crosslinking group). In addition, specific examples of these compounds include, but not particularly limited to, those described in International Publication No. WO 2013/024779. Note that these crosslinking agents can be used alone as one kind or can be used in combination of two or more kinds. Also, these crosslinking agents may be used as an additive. Note that the crosslinking group may be introduced into a polymer side chain in the tellurium containing compound and/or the tellurium containing silicon compound as a pendant group. Also, a compound containing a hydroxy group can be used as a crosslinking agent. Among them, a melamine compound, a glycoluril compound, and the like are particularly preferably used.

In the composition of the present embodiment, the content of the crosslinking agent is not particularly limited and is preferably 1 to 10 parts by mass, and more preferably 1 to 5 parts by mass based on 100 parts by mass of the tellurium containing compound and the silicon containing compound. By setting the content to the above range, occurrence of a mixing event with a resist layer tends to be suppressed. Also, an antireflection effect is enhanced, and crosslinking film formability tends to be enhanced.

The surfactant is effective for suppressing the occurrence of surface defects, when the composition for resist underlayer film formation is coated to a substrate. Examples of the surfactant contained in the composition for resist underlayer film formation include, for example, a nonionic surfactant such as a polyoxyethylene alkyl ether such as polyoxyethylene lauryl ether, polyoxyethylene stearyl ether, polyoxyethylene cetyl ether, and polyoxyethylene oleyl ether; a polyoxyethylenealkylaryl ether such as polyoxyethylene octylphenol ether and polyoxyethylene nonylphenol ether; a polyoxyethylene·polyoxypropylene block copolymer; a sorbitan fatty acid ester such as sorbitan monolaurate, sorbitan monopalmitate, sorbitan monostearate, sorbitan monooleate, sorbitan trioleate, and sorbitan tristearate; a polyoxyethylene sorbitan fatty acid ester such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate. These surfactants can be used alone or in combination of two or more. When the surfactant is used, the ratio thereof is, for example, 0.0001 parts by mass to 5 parts by mass, or 0.001 parts by mass to 1 part by mass, or 0.01 parts by mass to 0.5 parts by mass based on 100 parts by mass of the tellurium containing compound and the silicon containing compound.

### [Resist underlayer film for lithography]

The underlayer film for lithography of the present embodiment is formed from the composition for resist underlayer film formation of the present embodiment. The underlayer film for lithography of the present embodiment can be preferably used as an under layer (resist underlayer film) of a photoresist (upper layer) used in a multilayer resist method.

### [Pattern formation method]

The first pattern formation method of the present embodiment comprises: a resist underlayer film formation step of forming a resist underlayer film on a substrate using the composition of the present embodiment; a photoresist layer formation step of forming at least one photoresist layer on the resist underlayer film, and a development step of irradiating a predetermined region of the photoresist layer with radiation for development.

The second pattern formation method of the present embodiment comprises: an organic underlayer film formation step of forming an organic underlayer film on a substrate using a coating type organic under layer film material; a resist underlayer film formation step of forming a resist underlayer film on the organic underlayer film using the composition of the present embodiment; an upper layer resist film formation step of forming an upper layer resist film on the resist underlayer film using an upper layer resist film composition; an upper layer resist pattern formation step of forming an upper layer resist pattern on the upper layer resist film; a resist underlayer film transfer step of transferring the pattern to the resist underlayer film by etching using the upper layer resist pattern as a mask; an organic underlayer film transfer step of transferring the pattern to the organic underlayer film by etching using the resist underlayer film to which the pattern is transferred as a mask; and a substrate transfer step of transferring the pattern to the substrate (object to be processed) by etching using the organic underlayer film to which the pattern is transferred as a mask.

The third pattern formation method of the present embodiment comprises: an organic hard mask formation step of forming an organic hard mask containing carbon as a main component on a substrate by chemical vapor deposition; a resist underlayer film formation step of forming a resist underlayer film on the organic hard mask using the composition of the present embodiment; an upper layer resist film formation step of forming an upper layer resist pattern on the resist underlayer film using an upper layer resist film composition; an upper layer resist pattern formation step of forming an upper layer resist film on the upper layer resist film; a resist underlayer film transfer step of transferring the pattern to the resist underlayer film by etching using the upper layer resist pattern as a mask; an organic hard mask transfer step of transferring the pattern to the organic hard mask by etching using the resist underlayer film to which the pattern is transferred as a mask; and a substrate transfer step of transferring the pattern to the substrate by etching using the organic hard mask to which the pattern is transferred as a mask.

As the base material, for example, a semiconductor substrate can be used. As the semiconductor substrate, a silicon substrate can be generally used, but not particularly limited thereto, and a material different from those used in the layer to be processed, such as Si, amorphous silicon (α-Si), p-Si, SiO₂, SiN, SiON, W, TiN, and Al, can be used. Also, as the metal constituting the base material (the object to be processed; including the above-described semiconductor substrate), any of silicon, titanium, tungsten, hafnium, zirconium, chromium, germanium, copper, aluminum, indium, gallium, arsenic, palladium, iron, tantalum, iridium, or molybdenum, or alloys thereof can be used.

In addition, as the layer to be processed (to-be-processed portion) on the semiconductor substrate, one formed of any of a metal film, a metal carbide film, a metal oxide film, a metal nitride film, a metal oxycarbide film, or a metal oxynitride film, or the like can be used. As the layer to be processed containing such a metal, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, and the like, and various low dielectric films and etching stopper films thereof are used, and it may normally be formed to have a thickness of 50 to 10,000 nm, in particular, 100 to 5,000 nm.

In each pattern formation method of the present embodiment, an organic underlayer film or an organic hard mask can be formed on a substrate. Among them, the organic underlayer film can be formed from a coating type organic under layer film material by using a spin-coating method, and the like, and the organic hard mask can be formed from an organic hard mask material containing carbon as a main component by using a CVD method. The type of such an organic underlayer film and an organic hard mask is not particularly limited, but when the upper layer resist film is subjected to pattern formation by exposure, it preferably expresses a sufficient antireflection film function. By forming such an organic underlayer film or an organic hard mask, the pattern formed on the upper layer resist film can be transferred on a base material (object to be processed) without generating the difference in size conversion. Note that the hard mask "containing carbon as a main component" refers to a hard mask made of a carbon-based material such as an amorphous hydrogenated carbon, 50% by mass or more of the solid matter of which is referred to as amorphous carbon and which is designated as a-C:H. Although the a-C:H film can be deposited by different techniques, plasma enhanced chemical vapor deposition (PECVD) is widely used due to cost efficiency and film property tunability. As an example of the hard mask, for example, reference can be made to those described in Japanese Translation of PCT International Application Publication No. 2013-526783.

The resist underlayer film formed by using the composition for resist underlayer film formation of the present invention used in the method for forming each pattern of the present embodiment can be produced on an object to be processed on which an organic underlayer film, and the like are provided by a spin-coating method or the like from the composition for resist underlayer film formation. When the resist underlayer film is formed by a spin-coating method, it is desirably baked after spin-coating to promote the crosslinking reaction for the purpose of evaporating the solvent and preventing mixing with the upper layer resist film. The baking temperature is preferably within the range of 50 to 500°C. At this time, the baking temperature is, although it depends on the structure of the device to be produced, particularly preferably 400°C or less in order to reduce thermal damage to the device. The baking time to be used is preferably within the range of 10 seconds to 300 seconds.

In each pattern formation method of the present embodiment, any one of a lithographic method using light having a wavelength of 300 nm or less or EUV light; an electron beam direct writing method, and a directed self-assembly method can be preferably used as a method for forming a pattern on the upper layer resist film. By using such methods, a fine pattern can be formed on the resist upper layer film.

The upper layer resist film composition can be arbitrarily selected depending on the method for forming a pattern on the upper layer resist film mentioned above. For example, when a lithography using light having a wavelength of 300 nm or less or EUV light is performed, a chemically amplified photoresist film material can be used as the upper layer resist film composition. Such a photoresist film material can be exemplified by a material in which a positive type pattern is formed by forming a photoresist film, exposing the photoresist film, and then dissolving the exposed portion using an alkaline developing solution, or a material in which a negative type pattern is formed by dissolving an unexposed portion using a developing solution composed of an organic solvent.

The resist underlayer film formed from the composition for resist underlayer film formation of the present embodiment may absorb light used in a lithography process depending on the wavelength of the light. In such a case, the resist underlayer film can function as an antireflection film having the effect of preventing a reflection light on the substrate.

In addition, the resist underlayer film can be used as an underlayer film of an EUV resist also for the following purpose in addition to the functions as a hard mask. The tellurium containing composition for resist underlayer film formation can be used as an under layer antireflection film of the EUV resist, which causes no intermixing with the EUV resist and can prevent the reflection of the unpreferable exposure light, for example, the UV or DUV (ArF light, KrF light) mentioned above, from a substrate or an interface during EUV exposure (wavelength: 13.5 nm). The tellurium containing composition for resist underlayer film formation can efficiently prevent reflection at the underlayer of the EUV resist. In addition, the composition for underlayer film formation is excellent in EUV absorbing ability and thus can have a sensitizing action of the upper layer resist composition, contributing to the improvement of the sensitivity. When the composition for underlayer film formation is used as an EUV resist underlayer film, the process can be carried out in the same manner as that of the underlayer film for photoresist.

### Examples

Hereinafter, the present invention will be explained in more detail by way of Production Examples and Examples; however, the present invention is not limited by these examples in any way.

### [Measurement method]

### (Structure of compound)

The structure of a compound was confirmed by carrying out ¹H-NMR measurement using "Advance 600II spectrometer" manufactured by Bruker Inc. under the following conditions.

Frequency: 400 MHz
Solvent: d6-DMSO
Internal standard: tetramethylsilane (TMS)
Measurement temperature: 23°C

### (Molecular weight)

The molecular weight of a compound was measured by LC-MS analysis using "Acquity UPLC/MALDI-Synapt HDMS" manufactured by Water. Inc.

### (Weight average molecular weight (Mw), number average molecular weight (Mn), and dispersity (Mw/Mn))

The weight average molecular weight (Mw), number average molecular weight (Mn), and dispersibility (Mw/Mn) in terms of polystyrene were determined by gel permeation chromatography (GPC) analysis.

Apparatus: "Shodex GPC-101 model" manufactured by Showa Denko K.K.

Column: "KF-80M" x 3 manufactured by Showa Denko K.K.

Eluent: tetrahydrofuran (hereinafter, also referred to as "THF")
Flow rate: 1 mL/min
Temperature: 40°C

### [Synthesis Example 1]

3.08 g (10 mmol) of a compound (TOX-1) represented by the following formula (TOX-1), 14.56 g (70 mmol) of tetraethoxysilane, 5.56 g (20 mmol) of β-glycidoxyethyltriethoxysilane, and 60 g of acetone were placed into a 300 ml flask, and 0.1 g of methanesulfonic acid was added dropwise to the mixed solution while stirring the mixed solution with a magnetic stirrer. After the addition, the flask was transferred into an oil bath adjusted to 85°C and the mixture was allowed to react for 240 minutes under heat and reflux. Thereafter, the reaction solution was cooled to the room temperature, and 72.00 g of propylene glycol monomethyl ether acetate was added to the reaction solution, followed by distilling off ethanol, water, and acetone, which are reaction by-products, under reduced pressure, and concentrating to obtain a propylene glycol monomethyl ether acetate solution of a hydrolysis condensate. To the obtained solution, propylene glycol monomethyl ether acetate and propylene glycol monoethyl ether were added to make a solvent ratio of propylene glycol monomethyl ether acetate/propylene glycol monoethyl ether 20/80, whereby the concentration was adjusted to 15% by mass in terms of solid residue at 140°C. The weight average molecular weight Mw of the obtained polymer (tellurium containing silicon compound) measured by GPC was found to be 1400 in terms of polystyrene.

Te(OEt)₄ (TOX-1)

### [Synthesis Example 2]

In a container (internal capacity: 100 mL) equipped with a stirrer, a condenser tube, and a burette, 1.0 g (2.8 mmol) of tetraethoxytellurium(IV) (product from Alfa Aesar, purity 85%) dissolved in 20 mL of tetrahydrofuran was placed, and 0.6 g (6.0 mmol) of acetylacetone dissolved in 5 mL of tetrahydrofuran was further added. After refluxing the mixture for 1 hour, the solvent was distilled off under reduced pressure to obtain 0.6 g of a compound represented by the following formula (TOX-2).

From the chemical shift of ¹H-NMR before and after the reaction, it was confirmed that the compound represented by the formula (TOX-2) was obtained.

### [Table 1]

**Table 1**

| Ligand | Proton | Chemical shift (ppm) | |
|---|---|---|---|
| | | Before reaction | After reaction |
| Acetylacetone | -CH₃ | 2.2 | 2.3 |
| | -CH₂-(Keto form) | 3.6 | Not observed |
| | -CH= (Enol form) | 5.5 | 5.4 |
| | -OH (Enol form) | 15.8 | Not observed |

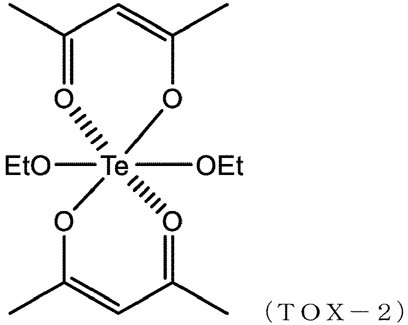

The same operations as in Synthesis Example 1 were carried out except that 4.17 g (10 mmol) of the compound obtained above (TOX-2) was used instead of 3.08 g (10 mmol) of the compound (TOX-1) of Synthesis Example 1. A polymer (tellurium containing silicon compound) having a weight average molecular weight Mw of 1460 was obtained.

### [Synthesis Example 3]

In a container (internal capacity: 100 mL) equipped with a stirrer, a condenser tube, and a burette, 1.0 g (2.8 mmol) of tetraethoxytellurium(IV) (product from Alfa Aesar, purity 85%) dissolved in 20 mL of tetrahydrofuran was placed, and 0.8 g (5.6 mmol) of 2,2-dimethyl-3,5-hexanedione dissolved in 5 mL of tetrahydrofuran was further added. After refluxing the mixture for 1 hour, the solvent was distilled off under reduced pressure to obtain 0.7 g of a compound represented by the following formula (TOX-3).

From the chemical shift of ¹H-NMR before and after the reaction, it was confirmed that the compound represented by the formula (TOX-3) was obtained.

### [Table 2]

**Table 2**

| Ligand | Proton | Chemical shift (ppm) | |
|---|---|---|---|
| | | Before reaction | After reaction |
| 2,2-Dimethyl-3,5-hexanedione | -(CH₃)₃ | 1.2 | 1.3 |
| | -CH₃ | 2.1 | 2.2 |
| | -CH₂-(Keto form) | 3.7 | Not observed |
| | -CH= (Enol form) | 5.7 | 5.6 |
| | -OH (Enol form) | 15.8 | Not observed |

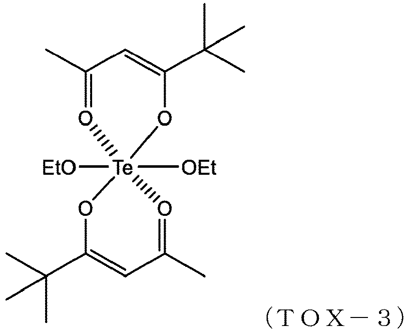

The same operations as in Synthesis Example 1 were carried out except that 5.02 g (10 mmol) of the compound obtained above (TOX-3) was used instead of 3.08 g (10 mmol) of the compound (TOX-1) of Synthesis Example 1. A polymer (tellurium containing silicon compound) having a weight average molecular weight Mw of 1510 was obtained.

### [Synthesis Example 4]

In a container (internal capacity: 100 mL) equipped with a stirrer, a condenser tube, and a burette, 1.0 g (2.8 mmol) of tetraethoxytellurium(IV) (product from Alfa Aesar, purity 85%) dissolved in 20 mL of tetrahydrofuran was placed, and 0.5 g (5.8 mmol) of methacrylic acid was further added. After refluxing the mixture for 1 hour, the solvent was distilled off under reduced pressure to obtain 0.5 g of a compound represented by the following formula (TOX-4).

From the chemical shift of ¹H-NMR before and after the reaction, it was confirmed that the compound represented by the formula (TOX-4) was obtained.

### [Table 3]

**Table 3**

| Ligand | Proton | Chemical shift (ppm) | |
|---|---|---|---|
| | | Before reaction | After reaction |
| Methacrylic acid | -CH₃ | 2.0 | 1.9 |
| | =CH₂ ① | 5.7 | 5.6 |
| | =CH₂ ② | 6.3 | 6.2 |
| | -COOH | 12.0 | 7.9 |

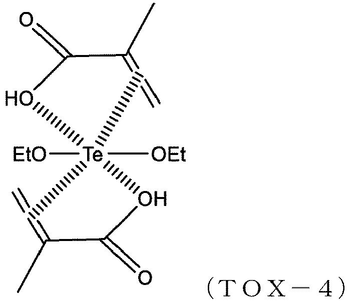

The same operations as in Synthesis Example 1 were carried out except that 4.70 g (10 mmol) of the compound obtained above (TOX-4) was used instead of 3.08 g (10 mmol) of the compound (TOX-1) of Synthesis Example 1. A polymer (tellurium containing silicon compound) having a weight average molecular weight Mw of 1490 was obtained.

### [Synthesis Example 5]

The same operations as in Synthesis Example 1 were carried out except that 0.31 g of "di-tertiary butyl diphenyl iodonium nonafluoromethane sulfonate (DTDPI)", which is an acid generating agent, manufactured by Midori Kagaku Co., Ltd., and 0.31 g of "NIKALAC MX270 (NIKALAC)", which is an acid crosslinking agent, manufactured by Sanwa Chemical Co., Ltd. were used in addition to 3.08 g (10 mmol) of the compound (TOX-1) of Synthesis Example 1. A polymer (tellurium containing silicon compound) having a weight average molecular weight Mw of 1510 was obtained.

### [Synthesis Example 6]

The same operations as in Synthesis Example 1 were carried out except that 3.08 g (10 mmol) of the compound (TOX-1) of Synthesis Example 1, 0.31 g of "di-tertiary butyl diphenyl iodonium nonafluoromethane sulfonate (DTDPI)", which is an acid generating agent, manufactured by Midori Kagaku Co., Ltd., and 0.31 g of "NIKALAC MX270 (NIKALAC)", which is an acid crosslinking agent, manufactured by Sanwa Chemical Co., Ltd., and 0.03 g of "Irgacure 184", which is a polymerization initiator, manufactured by BASF were used instead of 3.08 g (10 mmol) of the compound (TOX-1) of Synthesis Example 1. A polymer (tellurium containing silicon compound) having a weight average molecular weight Mw of 1500 was obtained.

### [Comparative Synthesis Example 1]

8.34 g (30 mol%) of β-glycidoxyethyltriethoxysilane, 14.56 g (70 mol%) of tetraethoxysilane, and 60 g of acetone was placed into a 300 ml flask, and 0.1 g of methanesulfonic acid was added dropwise to the mixed solution while stirring the mixed solution with a magnetic stirrer. After the addition, the flask was transferred into an oil bath adjusted to 85°C and the mixture was allowed to react for 240 minutes under heat and reflux. Thereafter, the reaction solution was cooled to the room temperature, and 72.00 g of propylene glycol monomethyl ether acetate was added to the reaction solution, followed by distilling off ethanol, water, and acetone, which are reaction by-products, under reduced pressure, and concentrated to obtain a propylene glycol monomethyl ether acetate solution of a hydrolysis condensate. To the obtained solution, propylene glycol monomethyl ether acetate and propylene glycol monoethyl ether were added to make a solvent ratio of propylene glycol monomethyl ether acetate/propylene glycol monoethyl ether 20/80, whereby the concentration was adjusted to 15% by mass in terms of solid residue at 140°C. The weight average molecular weight Mw of the obtained polymer measured by GPC was found to be 1610 in terms of polystyrene.

### [Example 1]

### (Preparation of composition for resist underlayer film formation)

640 g of propylene glycol monomethyl ether, and 80 g of deionized water were added in 160 g of a 15% by mass solution of the tellurium containing silicon compound obtained in Synthesis Example 1 and uniformly stirred, and thereafter, subjected to circulation filtration for 1 hour by a filter made of a polyethylene having an aperture of 5 nm with a flow rate of 10mL/min. to prepare a composition for resist underlayer film formation.

### [Measurement of optical constant]

Then, the composition for resist underlayer film formation was filled in a clean container and then spin-coated at 1500 rpm on a silicon wafer using a spin coater, and the silicon wafer is heated at 240°C for 60 seconds to produce a coating film having a film thickness of 35 nm. The refractive index (n value) and the optical absorptivity ("k value", or also referred to as the "extinction coefficient") of these resist underlayer films at a wavelength of 193 nm were measured using a spectroscopic ellipsometer (manufactured by J. A. Woollam, M-2000 DI-YK). The results are shown in Table 4 below.

### (Preparation of composition for organic underlayer film formation)

To a container (internal capacity: 100 mL) equipped with a stirrer, a condenser tube, and a burette, 1.60 g (10 mmol) of 2,6-naphthalenediol (a reagent manufactured by Sigma-Aldrich), 1.82 g (10 mmol) of 4-biphenylaldehyde (manufactured by Mitsubishi Gas Chemical Company, Inc.), and 30 ml of methyl isobutyl ketone were charged, and 5 ml of 95% sulfuric acid was added. The reaction solution was stirred at 100°C for 6 hours and reacted. Next, the reaction liquid was concentrated. The reaction product was precipitated by the addition of 50 g of pure water. After cooling to room temperature, the precipitates were separated by filtration. The obtained solid matter was filtered, dried, and then separated and purified by column chromatography to obtain 3.05 g of the objective compound (BisN-1) represented by the following formula. The following peaks were found by 400 MHz-¹H-NMR, and the compound was confirmed to have a chemical structure of the following formula. From the doublets of proton signals at positions 3 and 4, it was confirmed that the substitution position of 2,6-dihydroxynaphthol was position 1.

¹H-NMR: (d-DMSO, internal standard TMS)

δ (ppm) 9.7 (2H, O-H), 7.2-8.5 (19H, Ph-H), 6.6 (1H, C-H)

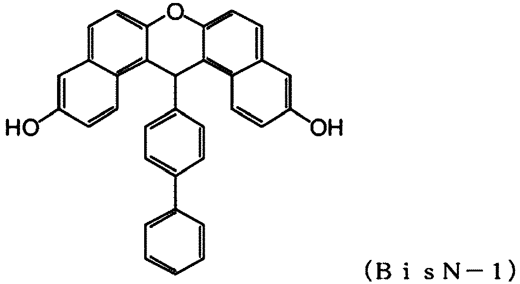

Into 2.0 g of the obtained compound (BisN-1), 18.0 g of ethyl lactate was added to make a uniform solution, and then filtered by a filter made of a polyethylene having an aperture of 5 nm to prepare a composition for organic underlayer film formation.

### (Preparation of photoresist solution)

Into a temperature-controllable autoclave (internal capacity: 500 mL) equipped with an electromagnetic stirrer (made of SUS316L), 74.3 g (3.71 mol) of anhydrous HF and 50.5 g (0.744 mol) of BF₃ were charged, the content was stirred, and the pressure was increased with carbon monoxide to 2 MPa while maintaining the liquid temperature at -30°C. Thereafter, while maintaining the pressure at 2 MPa and the liquid temperature at -30°C, a raw material obtained by mixing 57.0 g (0.248 mol) of 4-cyclohexylbenzene and 50.0 g of n-heptane was supplied and maintained for 1 hour, then the content was collected and placed in ice, diluted with benzene, and an oil layer obtained by neutralization treatment was analyzed by gas chromatography. The reaction performance was determined that the 4-cyclohexylbenzene inversion rate was 100% and the 4-cyclohexylbenzaldehyde selection rate was 97.3%. The target component was isolated by simple distillation and analyzed by GC-MS, and the result exhibited a molecular weight of 188, which was 4-cyclohexylbenzaldehyde (hereinafter, referred to as CHBAL) as the target product. That is, the molecular weight was measured using GC-MS QP2010 Ultra manufactured by Shimadzu Corporation. The chemical shift values of ¹H-NMR in a deuterated chloroform solvent (δ ppm, TMS standard) were 1.0 to 1.6 (m,10H), 2.6 (m,1H), 7.4 (d,2H), 7.8 (d,2H), and 10.0 (s,1H).

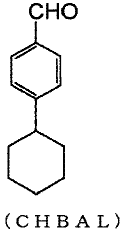

After the inside of a four necked flask (1000 mL) sufficiently dried, substituted with nitrogen, and equipped with a dropping funnel, a Dimroth condenser tube, a thermometer, and a stirring blade was sufficiently dried and substituted with nitrogen, resorcinol (22 g, 0.2 mol) manufactured by Kanto Chemical Co., Inc., 4-cyclohexylbenzaldehyde (46.0 g, 0.2 mol), and dehydrated ethanol (200 mL) were loaded into the four necked flask under a nitrogen stream to prepare an ethanol solution. This solution was heated to 85°C in a mantle heater while stirring. Then, after 75 mL of concentrated hydrochloric acid (35%) was added dropwise by a dropping funnel for 30 minutes, and continuously stirred at 85°C for 3 hours. After completion of the reaction, the mixture was allowed to cool, and after reaching to room temperature, the mixture was cooled in an ice bath. After standing still for 1 hour, a pale yellow target crude crystal was produced, which was filtered off. The crude crystal was washed with 500 mL of methanol twice, filtered off, and dried under vacuum to obtain 50 g of a product (hereinafter, referred to as "CR-1A"). As a result of LC-MS, the structure of this product exhibited a molecular weight of 1121. The chemical shift values of ¹H-NMR in a deuterated chloroform solvent (δ ppm, TMS standard) were 0.8 to 1.9 (m,44H), 5.5, 5.6 (d,4H), 6.0 to 6.8 (m,24H), 8.4, and 8.5 (m,8H).

From these results, the obtained product was identified as the objective compound (CR-1A) (yield: 91%) .

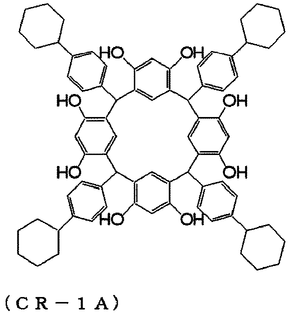

The obtained compound (CR-1A): 80 parts by mass, hexamethoxymethyl melamine: 20 parts by mass, triphenylsulfonium trifluoromethanesulfonate: 20 parts by mass, tributylamine: 3 parts by mass, and propylene glycol monomethyl ether: 5000 parts by mass were blended to prepare a photoresist solution.

### (Measurement of dry etching rate)

The solution of the composition for resist underlayer film formation was coated on a silicon wafer using a spin coater. The composition was heated on a hot plate at 240°C for 1 minute to form a tellurium containing resist underlayer film (film thickness: 100 nm). Similarly, the composition for organic underlayer film formation (10% by mass ethyl lactate solution of BisN-1) was coated on a silicon wafer using a spin coater to form an organic underlayer film having a film thickness of 200 nm. The dry etching rate was measured using O₂ gas as the etching gas, and the dry etching rate of the tellurium containing resist underlayer film was compared, thereby evaluating the resistance to the oxygen-based etching gas (oxygen-based gas resistance). RIE-10NR (manufactured by SAMCO Inc.):O₂ was used as the etcher and the etching gas used in the measurement of the dry etching rate. The oxygen-based gas (O₂ gas) resistance (the etch rate ratio [resist underlayer film of the present application]/[organic underlayer film]) is shown in Table 1 below. When the resist underlayer film of the present application is used as a material having high oxygen-based gas (O₂ gas) resistance as compared with that of the organic underlayer film, the etch rate ratio needs to be 1 or less, and preferably 0.5 or less, further preferably 0.2 or less, and further preferably 0.1 or less, in practical use.

### (Resist patterning test)

The composition for organic underlayer film formation was coated on a silicon wafer using a spin coater to form an organic underlayer film having a film thickness of 200 nm. The composition for resist underlayer film formation was coated thereon and heated at 240°C for 60 seconds to produce a tellurium containing resist underlayer film having a film thickness of 35 nm. Subsequently, the photoresist solution was coated thereon with a spinner and baked on a hot plate at 110°C for 90 seconds to form a photoresist film having a film thickness of 40 nm. Then, the above photoresist film was exposed using an electron beam lithography system (manufactured by ELIONIX INC.; ELS-7500, 50 keV), baked (PEB) at 110°C for 90 seconds, and developed for 30 seconds in a 2.38% by mass tetramethylammonium hydroxide (TMAH) aqueous solution to obtain a 50 nm 1:1 negative type line and space pattern. The resist pattern after lithography was observed, and in the skirt shape of the resist pattern, a rectangle line was evaluated as "rectangle", and a line having wider bottom was evaluated as "poor". The results are shown in Table 4 below.

### [Example 2]

The coating film was produced in the same manner as in Example 1 except that 160 g of the 15% by mass solution of the hydrolysis condensate of the silicon compound obtained in Synthesis Example 2 was used instead of the tellurium containing silicon compound obtained in Synthesis Example 1, and various evaluations were performed.

### [Example 3]

The coating film was produced in the same manner as in Example 1 except that 160 g of the 15% by mass solution of the hydrolysis condensate of the silicon compound obtained in Synthesis Example 3 was used instead of the tellurium containing silicon compound obtained in Synthesis Example 1, and various evaluations were performed.

### [Example 4]

The coating film was produced in the same manner as in Example 1 except that 160 g of the 15% by mass solution of the hydrolysis condensate of the silicon compound obtained in Synthesis Example 4 was used instead of the tellurium containing silicon compound obtained in Synthesis Example 1, and various evaluations were performed.

### [Example 5]

The coating film was produced in the same manner as in Example 1 except that 160 g of the 15% by mass solution of the hydrolysis condensate of the silicon compound obtained in Synthesis Example 5 was used instead of the tellurium containing silicon compound obtained in Synthesis Example 1, and various evaluations were performed.

### [Example 6]

The coating film was produced in the same manner as in Example 1 except that 160 g of the 15% by mass solution of the hydrolysis condensate of the silicon compound obtained in Synthesis Example 6 was used instead of the tellurium containing silicon compound obtained in Synthesis Example 1, and various evaluations were performed.

### [Comparative Example 1]

The coating film was produced in the same manner as in Example 1 except that 160 g of the 15% by mass solution of the hydrolysis condensate of the silicon compound obtained in Comparative Synthesis Example 1 was used instead of the tellurium containing silicon compound obtained in Synthesis Example 1, and various evaluations were performed.

### [Table 4]

**Table 4**

| | Refractive index | Optical absorption coefficient | Dry etching rate | Resist pattern |
|---|---|---|---|---|
| | | | Oxygen-based gas resistance | Pattern shape |
| Example 1 | 1.72 | 0.30 | 0.01 | Rectangle |
| Example 2 | 1.71 | 0.28 | 0.01 | Rectangle |
| Example 3 | 1.73 | 0.33 | 0.01 | Rectangle |
| Example 4 | 1.71 | 0.30 | 0.01 | Rectangle |
| Example 5 | 1.70 | 0.38 | 0.01 | Rectangle |
| Example 6 | 1.70 | 0.39 | 0.01 | Rectangle |
| Comparative Example 1 | 1.56 | 0.05 | 0.02 | Poor |

As can be seen from Table 4, in Examples using the composition for underlayer film formation of the present invention containing a tellurium containing silicon compound, the refractive index, optical absorptivity, and pattern formability are excellent and the resistance to the oxygen-based etching gas (oxygen-based gas resistance) is also found to be a preferred property in practical use.

Furthermore, by using the composition for resist underlayer film formation of the present application which contains both a tellurium containing compound and a silicon compound or a tellurium containing silicon compound, the coating films of Examples cause no intermixing with the resist, have high dry etching rate to fluorine-based etching gas as compared with that of the resist, enable to transfer a resist pattern to the resist underlayer film of the present application, exhibit the etching resistance to oxygen-based etching gas, and enable to transfer a resist pattern to the organic underlayer film. It was also shown that a good pattern can be obtained as compared with Comparative Example. As long as the requirements of the present invention are met, compounds other than the compounds described in Examples also exhibit the same effects.

### Industrial Applicability

The composition for resist underlayer film formation in the invention can be widely and effectively utilized in various applications in which the above performances are required. Besides, the invention can be particularly effectively utilized in the field of resist underlayer films for lithography, underlayer films for multi-layer resist, and pattern formation methods.

## Claims

1. A composition for resist underlayer film formation comprising a compound represented by the following formula (1) and a silicon containing compound:
[LₓTe(OR¹)_{y}] (1)
wherein L is a ligand other than OR¹; R¹ is any of a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, and a substituted or unsubstituted alkynyl group having 2 to 20 carbon atoms; x is an integer of 0 to 6; y is an integer of 0 to 6; the sum of x and y is 1 to 6; when x is 2 or more, a plurality of L may be the same or different; and when y is 2 or more, a plurality of R¹ may be the same or different.

2. A composition for resist underlayer film formation comprising a tellurium containing silicon compound being a reaction product of the compound represented by formula (1) and a silicon containing compound.

3. The composition for resist underlayer film formation according to claim 1 or 2, wherein the silicon containing compound is a hydrolyzable organosilane, a hydrolysate thereof, or a hydrolysis condensate thereof.

4. The composition for resist underlayer film formation according to any one of claims 1 to 3, wherein, in the compound represented by formula (1), x is an integer of 1 to 6.

5. The composition for resist underlayer film formation according to any one of claims 1 to 4, wherein, in the compound represented by formula (1), y is an integer of 1 to 6.

6. The composition for resist underlayer film formation according to any one of claims 1 to 5, wherein, in the compound represented by formula (1), R¹ is a substituted or unsubstituted linear alkyl group having 1 to 6 carbon atoms or branched or cyclic alkyl group having 3 to 6 carbon atoms.

7. The composition for resist underlayer film formation according to any one of claims 1 to 6, wherein, in the compound represented by formula (1), L is a bi- or higher dentate ligand.

8. The composition for resist underlayer film formation according to any one of claims 1 to 7, wherein, in the compound represented by formula (1), L is any of acetylacetonato, 2,2-dimethyl-3,5-hexanedione, ethylenediamine, diethylenetriamine, and methacrylic acid.

9. The composition for resist underlayer film formation according to any one of claims 1 to 8, further comprising a solvent.

10. The composition for resist underlayer film formation according to any one of claims 1 to 9, further comprising an acid generating agent.

11. The composition for resist underlayer film formation according to any one of claims 1 to 10, further comprising an acid crosslinking agent.

12. The composition for resist underlayer film formation according to any one of claims 1 to 11, further comprising an acid diffusion controlling agent.

13. The composition for resist underlayer film formation according to any one of claims 1 to 12, further comprising a polymerization initiator.

14. The composition for resist underlayer film formation according to any one of claims 1 to 13, wherein the silicon containing compound is at least one hydrolyzable organosilane selected from the group consisting of a compound represented by following formula (D1), a compound represented by following formula (D2), and a compound represented by following formula (D3), a hydrolysate thereof, or a hydrolysis condensate thereof:
(R³)ₐSi(R⁴)₄₋ₐ... (D1)
wherein R³ represents an alkyl group, an aryl group, an aralkyl group, a halogenated alkyl group, a halogenated aryl group, a halogenated aralkyl group, an alkenyl group, an epoxy group, an acryloyl group, a methacryloyl group, an alkoxyaryl group, an acyloxyaryl group, or a cyano group, or a group obtained by combining two or more of these groups, which groups optionally have a mercapto group, an isocyanurate group, a hydroxy group, or cyclic amino group as a substituent; R⁴ represents an alkoxy group, an acyloxy group, or a halogen group; and a represents an integer of 0 to 3,
[(R⁵)_{c}Si(R⁶)_{4-c}]₂Y... (D2)
(R⁵)_{c}Si(R⁶)_{4-c}... (D3)
wherein, R⁵ represents an alkyl group; R⁶ represents an alkoxy group, an acyloxy group, or a halogen group; Y represents an alkylene group or an arylene group; b represents an integer of 0 or 1; and c represents an integer of 0 or 1.

15. An underlayer film for lithography formed by using the composition for resist underlayer film formation according to any one of claims 1 to 14.

16. A pattern formation method comprising:
a resist underlayer film formation step of forming a resist underlayer film on a substrate using the composition for resist underlayer film formation according to any one of claims 1 to 14;
a photoresist layer formation step of forming at least one photoresist layer on the resist underlayer film; and
a development step of irradiating a predetermined region of the photoresist layer with radiation for development.

17. A pattern formation method comprising:
an organic underlayer film formation step of forming an organic underlayer film on a substrate using a coating type organic under layer film material;
a resist underlayer film formation step of forming a resist underlayer film on the organic underlayer film using the composition for resist underlayer film formation according to any one of claims 1 to 14;
an upper layer resist film formation step of forming an upper layer resist film on the resist underlayer film using an upper layer resist film composition;
an upper layer resist pattern formation step of forming an upper layer resist pattern on the upper layer resist film;
a resist underlayer film transfer step of transferring the pattern to the resist underlayer film by etching using the upper layer resist pattern as a mask;
an organic underlayer film transfer step of transferring the pattern to the organic underlayer film by etching using the resist underlayer film to which the pattern is transferred as a mask; and
a substrate transfer step of transferring the pattern to the substrate by etching using the organic underlayer film to which the pattern is transferred as a mask.

18. A pattern formation method comprising:
an organic hard mask formation step of forming an organic hard mask containing carbon as a main component on a substrate by chemical vapor deposition;
a resist underlayer film formation step of forming a resist underlayer film on the organic hard mask using the composition for resist underlayer film formation according to any one of claims 1 to 14;
an upper layer resist film formation step of forming an upper layer resist film on the resist underlayer film using an upper layer resist film composition;
an upper layer resist pattern formation step of forming an upper layer resist pattern on the upper layer resist film;
a resist underlayer film transfer step of transferring the pattern to the resist underlayer film by etching using the upper layer resist pattern as a mask;
an organic hard mask transfer step of transferring the pattern to the organic hard mask by etching using the resist underlayer film to which the pattern is transferred as a mask; and
a substrate transfer step of transferring the pattern to the substrate by etching using the organic hard mask to which the pattern is transferred as a mask.
